# EUROPEAN PATENT APPLICATION

(11) **EP 4 181 168 A1**
(43) Date of publication of application: **17.05.2023**
(21) Application number: 21207870.3
(22) Date of filing: 12.11.2021
(51) Int. Cl.: H01J 37/22

(54) **ALIGNING A DISTORTED IMAGE**

(71) Applicant: ASML Netherlands B.V., 5500 AH Veldhoven (NL)
(72) Inventor: VAN RENS, Jasper, Frans, Mathijs, 5500 AH Veldhoven (NL); HUISMAN, Thomas, Jarik, 5500 AH Veldhoven (NL); VAN MIERLO, Willem, Louis, 5500 AH Veldhoven (NL); DILLEN, Hermanus, Adrianus, 5500 AH Veldhoven (NL)
(74) Representative: ASML Netherlands B.V.

(57) **Abstract**

Disclosed herein is a non-transitory computer readable medium that has stored therein a computer program, wherein the computer program comprises code that, when executed by a computer system, instructs the computer system to perform a method of determining the charging induced distortion of a SEM image, the method comprising: determining, at each of a plurality of locations in a SEM image of at least part of a sample, a deflection of an illuminating charged particle beam caused by a charging of the sample at the location; and determining the charging induced distortion of the SEM image in dependence on the determined deflections at each of the plurality of locations in the SEM image. Block 3001: measuring distortion imaging error of the SEM image; block 3002: optionally further step on imaging error; either error from block 3001 or block 3002 used, in block 3003, in comparison with modelled charging induced distortions; block 3007: fixed and variable parameters of model of charging induced distortions determined; block 3005: model in dependence on the parameters; block 3006: optionally (e.g. 6 parameter polynomial fit correction); block 3003: comparison between model and imaging error; if measured remaining error at converged minimum level and/or below predetermined threshold, then stopped and determination made that variable parameters of model are suitable for achieving desired reduction or substantial correction of charging induced error in the SEM image; if measured remaining error not at a converged minimum level and/or not below predetermined threshold, continue at block 3008

## Description

### FIELD

The present disclosure relates to systems and methods for determining the charging induced distortion of a scanning electron microscope image and for reducing the charging induced distortion of the scanning electron microscope image.

### BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned.

Most semiconductor devices require a plurality of pattern layers to be formed and transferred onto the substrate. For proper functioning of the device, there is usually a limit on the tolerable error in the positioning of edges, quantified in an edge placement error or EPE. EPE can arise because of errors in the relative positioning of successive layers, known as overlay, or due to errors in the dimensions (specifically the critical dimension or CD) of features. With the continual desire in the lithographic art to reduce the size of features that can be formed (shrink), the limits on EPE are becoming stricter.

Overlay can arise from a variety of causes in the lithographic process, for example errors in the positioning of the substrate during exposure and aberrations in the projected image. Overlay can also be caused during process steps, such as etching, which are used to transfer the pattern onto the substrate. Some such process steps generate stresses within the substrate that lead to local or global distortions of the substrate. The formation of three dimensional structures on the substrate, such as is required for recently developed memory types and MEMS, can also lead to significant distortions of the substrate. CD variation can also derive from a variety of causes, including dose or focus errors.

### SUMMARY

The present disclosure aims to enable more accurate metrology, e.g. for use in lithographic device manufacturing processes.

According to a first aspect of the invention, there is provided a non-transitory computer readable medium that has stored therein a computer program, wherein the computer program comprises code that, when executed by a computer system, instructs the computer system to perform a method of determining the charging induced distortion of a SEM image, the method comprising: determining, at each of a plurality of locations in a SEM image of at least part of a sample, a deflection of an illuminating charged particle beam caused by a charging of the sample at the location; and determining the charging induced distortion of the SEM image in dependence on the determined deflections at each of the plurality of locations in the SEM image.

According to a second aspect of the invention, there is provided a non-transitory computer readable medium that has stored therein a computer program, wherein the computer program comprises code that, when executed by a computer system, instructs the computer system to perform a method of reducing charging induced distortion of a SEM image, the method comprising: determining the charging induced distortion of the SEM image in dependence on the method of the first aspect; and using the determined charging induced distortion to reduce the charging induced imaging error in the SEM image.

According to a third aspect of the invention, there is provided a system for determining the charging induced distortion of a SEM image, the system comprising the computer readable medium according to the first and/or second aspect.

According to a fourth aspect of the invention, there is provided a computer-implemented method of determining the charging induced distortion of a SEM image, the method comprising: determining, at each of a plurality of locations in a SEM image of at least part of a sample, a deflection of an illuminating charged particle beam caused by a charging of the sample at the location; and determining the charging induced distortion of the SEM image in dependence on the determined deflections at each of the plurality of locations in the SEM image.

According to a fifth aspect of the invention, there is provided a computer-implemented method of reducing charging induced distortion of a SEM image, the method comprising: determining the charging induced distortion of the SEM image in dependence on the method of the fourth aspect; and using the determined charging induced distortion to reduce the charging induced imaging error in the SEM image.

According to a sixth aspect of the invention, there is provided a computer program comprising code that, when executed by a computer system, instructs the computer system to perform the method according to the fourth and/or fifth aspect.

According to a seventh aspect of the invention, there is provided an inspection tool comprising: an imaging system configured to image a portion of a semiconductor substrate; and an image analysis system that comprises the system of the third aspect and is configured to perform a method for determining the charging induced distortion of a SEM image.

According to a eighth aspect of the invention, there is provided a method of manufacture of a semiconductor substrate, the method comprising the steps of: manufacturing at least part of the semiconductor substrate; performing the computer-implemented method according the fifth aspect; analyzing the aligned image to obtain a metric of the image; and comparing the metric to a target metric and taking remedial action when the metric does not meet the target metric.

According to a ninth aspect of the invention, there is provided a semiconductor substrate manufacturing system comprising apparatuses configured to perform the method of the eighth aspect.

According to a tenth aspect of the invention, there is provided a non-transitory computer readable medium that has stored therein a computer program, wherein the computer program comprises code that, when executed by a computer system, instructs the computer system to perform a method of reducing charging induced distortion of a SEM image, the method comprising: determining the charging induced distortion of a SEM image; and reducing charging induced distortion in the SEM image in dependence on the determined charging induced distortion.

According to a eleventh aspect of the invention, there is provided a system for determining the charging induced distortion of a SEM image, the system comprising the computer readable medium according to tenth aspect.

According to a twelfth aspect of the invention, there is provided a computer-implemented method of reducing charging induced distortion of a SEM image, the method comprising: determining the charging induced distortion of a SEM image; and reducing charging induced distortion in the SEM image in dependence on the determined charging induced distortion.

According to a thirteenth aspect of the invention, there is provided a non-transitory computer readable medium that has stored therein a computer program, wherein the computer program comprises code that, when executed by a computer system, instructs the computer system to perform a method of reducing charging induced distortion of a SEM image, the method comprising: modelling the charging induced distortion of a SEM image, wherein the model comprises estimating the deflection of an illuminating charged particle beam by a charge on an illuminated sample; and using the modelled charging induced distortion in the SEM image to reduce the charging induced distortion in the SEM image.

According to a fourteenth aspect of the invention, there is provided a system for determining the charging induced distortion of a SEM image, the system comprising the computer readable medium according to the thirteenth aspect.

According to a fifteenth aspect of the invention, there is provided a computer-implemented method of reducing charging induced distortion of a SEM image, the method comprising: modelling the charging induced distortion of a SEM image, wherein the model comprises estimating the deflection of an illuminating charged particle beam by a charge on an illuminated sample; and using the modelled charging induced distortion in the SEM image to reduce the charging induced distortion in the SEM image.

According to a sixteenth aspect of the invention, there is provided a non-transitory computer readable medium that has stored therein a computer program, wherein the computer program comprises code that, when executed by a computer system, instructs the computer system to perform a method of correcting charging induced distortion of a SEM image, the method comprising: determining, for each grid of a plurality of grids of a field of view, a deflection of an e-beam that results from charging of a sample by the e-beam; and correcting a distortion of a SEM image of the sample based on the determined deflections.

According to a seventeenth aspect of the invention, there is provided a system for determining the charging induced distortion of a SEM image, the system comprising the computer readable medium according to the sixteenth aspect.

According to a eighteenth aspect of the invention, there is provided a computer-implemented method of correcting charging induced distortion of a SEM image, the method comprising: determining, for each grid of a plurality of grids of a field of view, a deflection of an e-beam that results from charging of a sample by the e-beam; and correcting a distortion of a SEM image of the sample based on the determined deflections.

According to a nineteenth aspect of the invention, there is provided a non-transitory computer readable medium that has stored therein a computer program, wherein the computer program comprises code that, when executed by a computer system, instructs the computer system to perform the method of the eighteenth aspect.

According to a twentieth aspect of the invention, there is provided a system for determining the charging induced distortion of a SEM image, the system comprising the computer readable medium according to the nineteenth aspect.

Embodiments will now be described, by way of example, with reference to the accompanying drawings.

### BRIEF DESCRIPTION OF FIGURES

Figure 1A depicts a lithographic apparatus together with other apparatuses forming a production facility for semiconductor devices.
Figure 1B depicts an electron beam inspection system according to an embodiment;
Figure 1C depicts an exemplary imaging system according to an embodiment;
Figure 2A depicts an end on views of a multi-beam of charged particles in a SEM imaging process.
Figures 2B and 2C depict the deflection of a charged particle beam by charge build up on the surface of a substrate.
Figure 3 shows processing steps that may be performed to iteratively determine the variable parameters of a model for the determining the charging induced distortion in a SEM image.
Figure 4 is a flowchart of a method according to an embodiment.

### DETAILED DESCRIPTION

Electronic devices are constructed of circuits typically formed on a piece of silicon called a substrate, which may be referred to as a semiconductor substrate. Of course any other suitable material may be used for the substrate. Many circuits may be formed together on the same piece of silicon and are called integrated circuits or ICs. The size of these circuits has decreased dramatically so that many more of them can fit on the substrate. For example, an IC chip in a smartphone can be as small as a thumbnail and yet may include over 2 billion transistors, the size of each transistor being less than 1/1000th the size of a human hair.

Making these extremely small ICs is a complex, time-consuming, and expensive process, often involving hundreds of individual steps. Errors in even one step have the potential to result in defects in the finished IC, rendering it useless. Thus, one goal of the manufacturing process is to avoid such defects to maximize the number of functional ICs made in the process; that is, to improve the overall yield of the process.

One component of improving yield is monitoring the chip-making process to ensure that it is producing a sufficient number of functional integrated circuits. One way to monitor the process is to inspect the chip circuit structures at various stages of their formation. Inspection can be carried out using a scanning electron microscope (SEM), an optical inspection system, etc. Such systems can be used to image these structures, in effect, taking a "picture" of the structures of the wafer, with a SEM being able to image the smallest of these structures. The image can be used to determine if the structure was formed properly in the proper location. If the structure is defective, then the process can be adjusted, so the defect is less likely to recur.

In order to control errors in a lithographic manufacturing process, such as errors in the relative position of features in different layers (known as overlay) and the size of features (known as CD variation), it is necessary to measure the errors, such as by use of a scanning electron microscope (SEM), an optical inspection system, etc., before corrections can be applied. When using a SEM or other inspection system, images of the substrate are typically obtained and the size of features on the substrate are measured from the images. This allows, for example, determination of CD variation or EPE. However, the images obtained by inspection systems, for example a SEM, are often distorted. Such distortions may, for example, comprise field of view (FOV) distortions which arise as a result of limitations in the electron optical design (similar to e.g. pincushion and barrel distortion in optical systems), as well as effects due to charging (electron beam - sample interaction, leading to e.g. beam bending). As a result of the distortions, measurements of features on the substrate may not be wholly accurate and thus the distortions may introduce an error in the measurements. Given the small tolerances in the measurements of the features on such substrates, errors of this type are less than desirable and may cause the implementation of changes to the manufacturing process which are either not necessary or which are too extreme.

Some methods disclosed herein are directed towards reducing the distortion in SEM images that is caused by charging of the imaged substrate, or any other type of imaged sample.

In a SEM imaging process, a substrate is illuminated by a charged particle beam. The charged particle beam is typically an electron beam. The illumination process can cause charge to build up on parts of the illuminated surface of the substrate. A problem with charge build up on the surface of the substrate is that the built up charge may influence the path of an illuminating charged particle beam. For example, due to the physical property of like charges repelling each other, a negative charge build up on the surface of the substrate will deflect the path of an electron beam away from it. Charge build up, be it positive or negative charge build up, may therefore cause an illuminating beam to land at a different location on the surface of a substrate from an intended location.

Some of the methods disclosed herein provide techniques for determining the effect of charge build up on a substrate and thereby the charging induced distortion of a SEM image. For example, a model may be constructed for determining the deflection of each illuminating beam caused by the charging of the substrate. The model may determine deflection amounts based on the physical process of an illuminating beam being deflected by a surface charge on the substrate.

Some of the methods disclosed herein also provide techniques for reducing, or substantially correcting, the charging induced distortion of a SEM image. A SEM image may be processed, in dependence on the determined charging induced distortion of the SEM image, to substantially reduce, and/or correct for, the charging induced distortion in the SEM image.

Before describing embodiments in detail, it is instructive to present an example environment in which the techniques disclosed herein may be implemented.

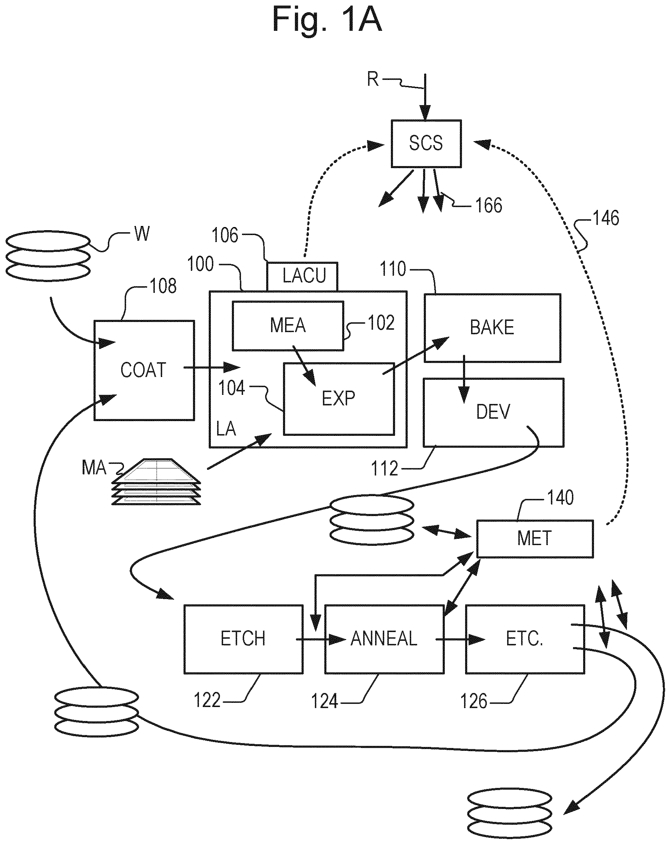

Figure 1A illustrates a typical layout of a semiconductor production facility. A lithographic apparatus 100 applies a desired pattern onto a substrate. A lithographic apparatus is used, for example, in the manufacture of integrated circuits (ICs). In that instance, a patterning device MA, which is alternatively referred to as a mask or a reticle, comprises a circuit pattern of features (often referred to as "product features") to be formed on an individual layer of the IC. This pattern is transferred onto a target portion (e.g., comprising part of, one, or several dies) on a substrate 'W' (e.g., a silicon wafer) via exposure 104 of the patterning device onto a layer of radiation-sensitive material (resist) provided on the substrate. In general, a single substrate will contain a network of adjacent target portions that are successively patterned.

Known lithographic apparatus irradiate each target portion by illuminating the patterning device while synchronously positioning the target portion of the substrate at an image position of the patterning device. An irradiated target portion of the substrate is referred to as an "exposure field", or simply "field". The layout of the fields on the substrate is typically a network of adjacent rectangles or other shapes aligned in accordance to a Cartesian two-dimensional coordinate system (e.g. aligned along an X and an Y-axis, both axes being orthogonal to each other).

A requirement on the lithographic apparatus is an accurate reproduction of the desired pattern onto the substrate. The positions and dimensions of the applied product features need to be within certain tolerances. Position errors may give rise to an overlay error (often referred to as "overlay"). The overlay is the error in placing a first product feature within a first layer relative to a second product feature within a second layer. The lithographic apparatus reduces the overlay errors by aligning each wafer accurately to a reference prior to patterning. This is done by measuring positions of alignment marks which are applied to the substrate. Based on the alignment measurements the substrate position is controlled during the patterning process in order to prevent occurrence of out of tolerance overlay errors. Alignment marks are typically created as part of the product image, forming the reference to which overlay is measured. Alternatively, alignment marks of a previously formed layer can be used.

An error in a critical dimension (CD) of the product feature may occur when the applied dose associated with the exposure 104 is not within specification. For this reason the lithographic apparatus 100 must be able to accurately control the dose of the radiation applied to the substrate. The exposure 104 is controlled by the measurement tool 102 which is integrated into the lithographic apparatus 100. CD errors may also occur when the substrate is not positioned correctly with respect to a focal plane associated with the pattern image. Focal position errors are commonly associated with non-planarity of a substrate surface. The lithographic apparatus reduces these focal position errors by measuring the substrate surface topography using a level sensor prior to patterning. Substrate height corrections are applied during subsequent patterning to assure correct imaging (focusing) of the patterning device onto the substrate.

To verify the overlay and CD errors associated with the lithographic process, the patterned substrates are inspected by a metrology apparatus 140. Common examples of a metrology apparatus are scatterometers and scanning electron microscopes.

A scatterometer conventionally measures characteristics of dedicated metrology targets. These metrology targets are representative of the product features, except that their dimensions are typically larger in order to allow accurate measurement. The scatterometer measures the overlay by detecting an asymmetry of a diffraction pattern associated with an overlay metrology target. Critical dimensions are measured by analysis of a diffraction pattern associated with a CD metrology target. A CD metrology target is used for measuring the result of the most recently exposed layer. An overlay target is used for measuring the difference between the positions of the previous and most recent layers.

An electron beam (e-beam) based inspection tool, such as a scanning electron microscope (SEM), may be well suited for the measurement of small overlay and CD values. In a SEM, a primary electron beam of electrons at a relatively high energy is targeted at a sample, sometimes with a final deceleration step in order to land on the sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary, backscattered, or Auger electrons may be emitted from the material structure of the sample. By scanning the primary electron beam as the probing spot over the sample surface, such electrons can be emitted across the surface of the sample. By collecting some or all of these types of electrons emitted from the sample surface, a pattern inspection tool may obtain an image representing characteristics of the material structure of the surface of the sample.

Within a semiconductor production facility, lithographic apparatus 100 and metrology apparatus 140 form part of a "litho cell" or "litho cluster". The litho cluster comprises also a coating apparatus 108 for applying photosensitive resist to substrates W, a baking apparatus 110, a developing apparatus 112 for developing the exposed pattern into a physical resist pattern, an etching station 122, apparatus 124 performing a post-etch annealing step and possibly further processing apparatuses, 126, etc.. The metrology apparatus 140 is configured to inspect substrates after development at development apparatus 112, or after further processing (e.g. etching at etching station 122). The various apparatus within the litho cell are controlled by a supervisory control system SCS, which issues control signals 166 to control the lithographic apparatus via lithographic apparatus control unit LACU 106 to perform recipe R. The SCS allows the different apparatuses to be operated giving maximum throughput and product yield. An important control mechanism is the feedback 146 of the metrology apparatus 140 to the various apparatus (via the SCS), in particular to the lithographic apparatus 100. Based on the characteristics of the metrology feedback, corrective actions are determined to improve processing quality of subsequent substrates. The SCS can be one computer or multiple computers, which may or may not communicate. The recipe R can be implemented as one recipe or as multiple independent recipes. For example, the recipe for a process step such as etch may be totally independent of the recipe to inspect the result of that process step (e.g. etch). For example, two or more recipes for individual steps may be interrelated such that one recipe is adjusted to take account of the results of performance of another recipe on the same or a different substrate.

The performance of a lithographic apparatus is conventionally controlled and corrected by methods such as advanced process control (APC) described for example in US2012008127A1. The advanced process control techniques use measurements of metrology targets applied to the substrate. A Manufacturing Execution System (MES) schedules the APC measurements and communicates the measurement results to a data processing unit. The data processing unit translates the characteristics of the measurement data to a recipe comprising instructions for the lithographic apparatus. This method is very effective in suppressing drift phenomena associated with the lithographic apparatus.

The processing of metrology data to corrective actions performed by the processing apparatus is important for semiconductor manufacturing. In addition to the metrology data, characteristics of individual patterning devices, substrates, processing apparatus and other context data may be needed to further optimize the manufacturing process. The framework wherein available metrology and context data is used to optimize the lithographic process as a whole is commonly referred to as part of holistic lithography. For example, context data relating to CD errors on a reticle may be used to control various apparatus (lithographic apparatus, etching station) such that said CD errors will not affect the yield of the manufacturing process. Subsequent metrology data may then be used to verify the effectiveness of the control strategy and further corrective actions may be determined.

To qualify the process window, separate CD and overlay measurements are performed with one or more of the existing tools and combined into an edge placement error (EPE) budget. Often, one metrology step might be performed after development (ADI) and another after an etch step (AEI), and there are inherent difficulties in calibrating two such different measurements to give equivalent results.

EPE is very important to ensure that a semiconductor device is working properly, for example it may affect whether, in a back end of line module, there is sufficient electrical contact. This makes EPE measurements very valuable to ensuring that the process window accommodates a sufficient EPE budget and to controlling the process to remain within window.

The metrology apparatus 140, that may comprise the above-described SEM, may obtain images of the semiconductor substrate in order to inspect and obtain measurements of the substrate. However, as mentioned previously, the image obtained by the metrology apparatus may be distorted. Field of view (FOV) distortions and charging artefacts affect the direct measurement and comparison of structures in different parts of the field, or between different images if the field of view changes.

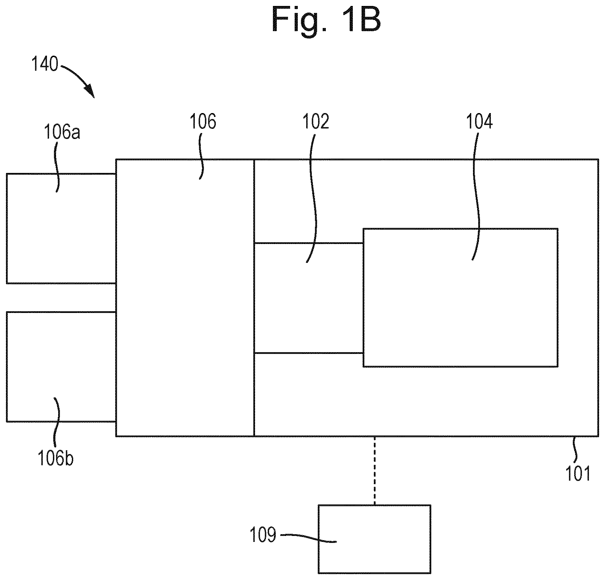

The SEM according to embodiments may be an electron beam inspection (EBI) system 140, as shown in Figure 1B. The EBI system 140 may be used for imaging. As shown in Fig. 1B, EBI system 140 may include a main chamber 101, a load/lock chamber 102, an electron beam tool 104, and an equipment front end module (EFEM) 106. Electron beam tool 104 is located within main chamber 101. While the description and drawings are directed to an electron beam, it is appreciated that the embodiments are not used to limit the present disclosure to specific charged particles.

EFEM 106 may include a first loading port 106a and a second loading port 106b. EFEM 106 may include additional loading port(s). First loading port 106a and second loading port 106b receive wafer front opening unified pods (FOUPs) that contain wafers (e.g., semiconductor wafers or wafers made of other material(s)) or samples to be inspected (wafers and samples may be used interchangeably).

One or more robotic arms (not shown) in EFEM 106 may transport the wafers to load/lock chamber 102. Load/lock chamber 102 is connected to a load/lock vacuum pump system (not shown) which removes gas molecules in load/lock chamber 102 to reach a first pressure below the atmospheric pressure. After reaching the first pressure, one or more robotic arms (not shown) may transport the wafer from load/lock chamber 102 to main chamber 101. Main chamber 101 is connected to a main chamber vacuum pump system (not shown) which removes gas molecules in main chamber 101 to reach a second pressure below the first pressure. After reaching the second pressure, the wafer is subject to inspection by electron beam tool 104. Electron beam tool 104 may be a single-beam system or a multi-beam system.

A controller 109 is electronically connected to electron beam tool 104 and may be electronically connected to other components as well. Controller 109 may be a computer configured to execute various controls of EBI system 140. Controller 109 may also include processing circuitry configured to execute various signal and image processing functions. While controller 109 is shown in Fig. 1B as being outside of the structure that includes main chamber 101, load/lock chamber 102, and EFEM 106, it is appreciated that controller 109 may be a part of the structure.

In some embodiments, controller 109 may include one or more processors (not shown). A processor may be a generic or specific electronic device capable of manipulating or processing information. For example, the processor may include any combination of any number of a central processing unit (or "CPU"), a graphics processing unit (or "GPU"), an optical processor, a programmable logic controllers, a microcontroller, a microprocessor, a digital signal processor, an intellectual property (IP) core, a Programmable Logic Array (PLA), a Programmable Array Logic (PAL), a Generic Array Logic (GAL), a Complex Programmable Logic Device (CPLD), a Field-Programmable Gate Array (FPGA), a System On Chip (SoC), an Application-Specific Integrated Circuit (ASIC), and any type circuit capable of data processing. The processor may also be a virtual processor that includes one or more processors distributed across multiple machines or devices coupled via a network.

In some embodiments, controller 109 may further include one or more memories (not shown). A memory may be a generic or specific electronic device capable of storing codes and data accessible by the processor (e.g., via a bus). For example, the memory may include any combination of any number of a random-access memory (RAM), a read-only memory (ROM), an optical disc, a magnetic disk, a hard drive, a solid-state drive, a flash drive, a security digital (SD) card, a memory stick, a compact flash (CF) card, or any type of storage device. The codes may include an operating system (OS) and one or more application programs (or "apps") for specific tasks. The memory may also be a virtual memory that includes one or more memories distributed across multiple machines or devices coupled via a network.

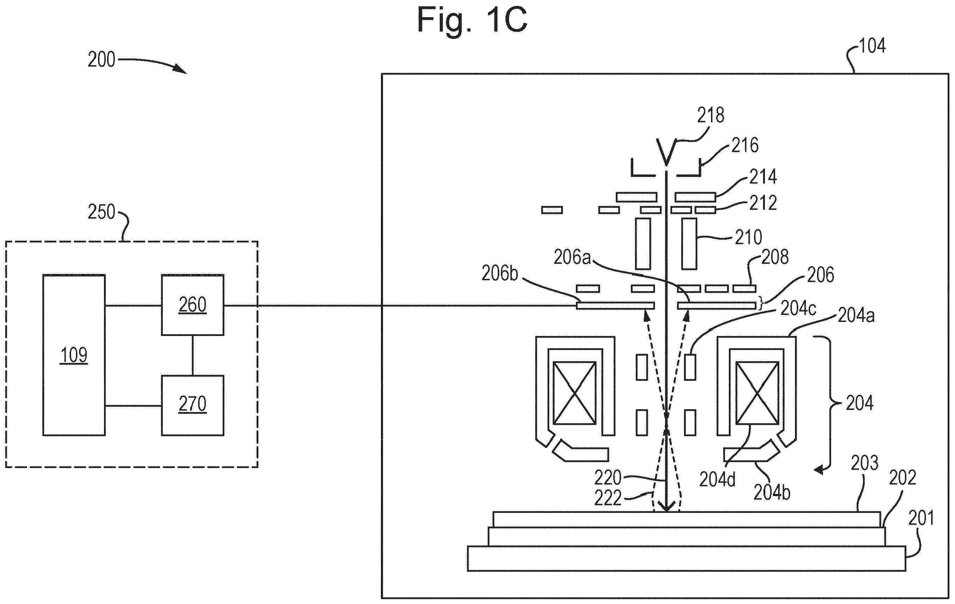

Reference is now made to Fig. 1C, which illustrates an exemplary imaging system 200 according to embodiments of the present disclosure. Electron beam tool 104 of Fig. 1C may be configured for use in EBI system 140. Electron beam tool 104 may be a single beam apparatus or a multi-beam apparatus. As shown in Fig. 1C , electron beam tool 104 may include a motorized sample stage 201, and a wafer holder 202 supported by motorized sample stage 201 to hold a wafer 203 as an example of a sample to be inspected. Electron beam tool 104 may further include an objective lens assembly 204, an electron detector 206 (which includes electron sensor surfaces 206a and 206b), an objective aperture 208, a condenser lens 210, a beam limit aperture 212, a gun aperture 214, an anode 216, and a cathode 218. Objective lens assembly 204, in some embodiments, may include a modified swing objective retarding immersion lens (SORIL), which includes a pole piece 204a, a control electrode 204b, a deflector 204c, and an exciting coil 204d.

A primary electron beam 220 is emitted from cathode 218 by applying an acceleration voltage between anode 216 and cathode 218. Primary electron beam 220 passes through gun aperture 214 and beam limit aperture 212, both of which may determine the size of electron beam entering condenser lens 210, which resides below beam limit aperture 212. Condenser lens 210 focuses primary electron beam 220 before the beam enters objective aperture 208 to set the size of the electron beam before entering objective lens assembly 204. Deflector 204c deflects primary electron beam 220 to facilitate beam scanning on the wafer. For example, in a scanning process, deflector 204c may be controlled to deflect primary electron beam 220 sequentially onto different locations of top surface of wafer 203 at different time points, to provide data for image reconstruction for different parts of wafer 203. Moreover, deflector 204c may also be controlled to deflect primary electron beam 220 onto different sides of wafer 203 at a particular location, at different time points, to provide data for stereo image reconstruction of the wafer structure at that location. Further, in some embodiments, anode 216 and cathode 218 may generate multiple primary electron beams 220, and electron beam tool 104 may include a plurality of deflectors 204c to project the multiple primary electron beams 220 to different parts/sides of the wafer at the same time, to provide data for image reconstruction for different parts of wafer 203.

In many cases, the electron beam(s) of an SEM are scanned across the sample in a two-dimensional raster pattern. The raster pattern comprises a slow movement in a first direction and a fast movement in a second direction. The second direction is perpendicular, or nearly perpendicular, to the first direction. The first direction may be referred to as the main-scanning direction or the slow scan direction and the second direction as the sub-scanning direction or fast scan direction. Unless otherwise specified, the scan direction referred to herein is the fast scan direction. Scanning can also be performed mechanically, through stage movement, or by a combination of mechanical scanning and scanning by a deflector. For example, the slow scan may be performed by stage movement and the fast scan by the deflector.

Exciting coil 204d and pole piece 204a generate a magnetic field that begins at one end of pole piece 204a and terminates at the other end of pole piece 204a. A part of wafer 203 being scanned by primary electron beam 220 may be immersed in the magnetic field and may be electrically charged, which, in turn, creates an electric field. The electric field reduces the energy of impinging primary electron beam 220 near the surface of wafer 203 before it collides with wafer 203. Control electrode 204b, being electrically isolated from pole piece 204a, controls an electric field on wafer 203 to prevent micro-arching of wafer 203 and to ensure proper beam focus.

A secondary electron beam 222 may be emitted from the part of wafer 203 upon receiving primary electron beam 220. Secondary electron beam 222 may comprise secondary electrons, backscatter electrons and other electrons emitted by the wafer 203 as discussed below. Secondary electron beam 222 may form a beam spot on sensor surfaces 206a and 206b of electron detector 206. Electron detector 206 may generate a signal (e.g., a voltage, a current, or the like.) that represents an intensity of the beam spot, and provide the signal to an image processing system 250. The intensity of secondary electron beam 222, and the resultant beam spot, may vary according to the external or internal structure of wafer 203. Moreover, as discussed above, primary electron beam 220 may be projected onto different locations of the top surface of the wafer or different sides of the wafer at a particular location, to generate secondary electron beams 222 (and the resultant beam spot) of different intensities. Therefore, by mapping the intensities of the beam spots with the locations of wafer 203, the processing system may reconstruct an image that reflects the internal or surface structures of wafer 203.

Imaging system 200 may be used for inspecting a wafer 203 on sample stage 201 and includes an electron beam tool 104, as discussed above. Imaging system 200 may also include an image processing system 250 that includes an image acquirer 260, storage 270, and controller 109. Image acquirer 260 may include one or more processors. For example, image acquirer 260 may include a computer, server, mainframe host, terminals, personal computer, any kind of mobile computing devices, and the like, or a combination thereof. Image acquirer 260 may connect with a detector 206 of electron beam tool 104 through a medium such as an electrical conductor, optical fiber cable, portable storage media, IR, Bluetooth, internet, wireless network, wireless radio, or a combination thereof. Image acquirer 260 may receive a signal from detector 206 and may construct an image. Image acquirer 260 may thus acquire images of wafer 203. Image acquirer 260 may also perform various post-processing functions, such as generating contours, superimposing indicators on an acquired image, and the like. Image acquirer 260 may perform adjustments of brightness and contrast, or the like of acquired images. Storage 270 may be a storage medium such as a hard disk, cloud storage, random access memory (RAM), other types of computer readable memory, and the like. Storage 270 may be coupled with image acquirer 260 and may be used for saving scanned raw image data as original images, and post-processed images. Image acquirer 260 and storage 270 may be connected to controller 109. In some embodiments, image acquirer 260, storage 270, and controller 109 may be integrated together as one control unit.

In some embodiments, image acquirer 260 may acquire one or more images of a sample based on an imaging signal received from detector 206. An imaging signal may correspond to a scanning operation for conducting charged particle imaging. An acquired image may be a single image including a plurality of imaging areas. The single image may be stored in storage 270. The single image may be an original image that may be divided into a plurality of regions. Each of the regions may include one imaging area containing a feature of wafer 203.

Charging artefacts are caused by charge build up on the surface of the substrate. In a SEM imaging process, a substrate is illuminated by a charged particle beam that is typically an electron beam. The illumination process can cause charge to build up on parts of the illuminated surface of the substrate. The charge build up on the surface may influence the path of an illuminating charged particle beam. For example, due to the physical property of like charges repelling each other, a negative charge build up on the surface of the substrate will deflect the path of an electron beam away from it. Charge build up, positive or negative, may therefore cause an illuminating beam to land at a different location on the surface of a substrate from an intended location.

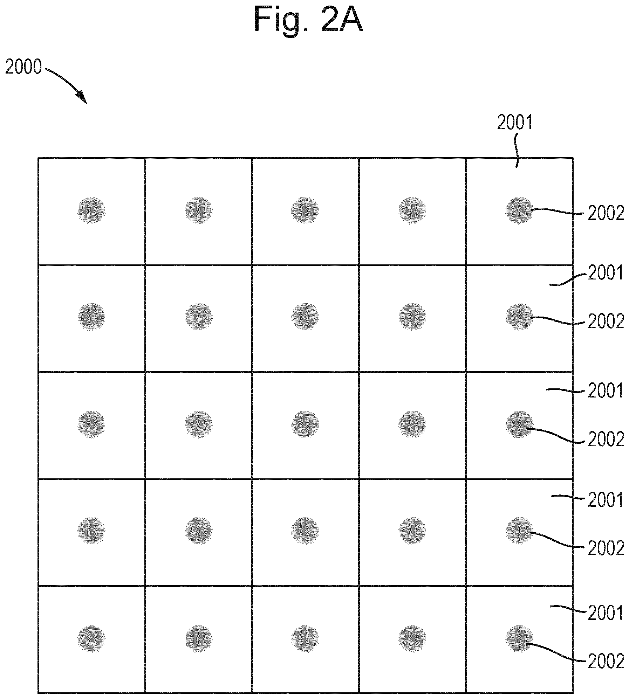

Figure 2A shows end on views, i.e. views along the direction of travel, of beams 2002 in a SEM imaging process. The overall view 2000 has been divided into a plurality of grids 2001. Within each grid 2001, an end-on view of an illuminating beam 2002 of a substrate is shown. The plurality of beams 2002 may be a multi-beam of charged particles. In a final stage of the column that generates the multi-beam, the beam paths may all be substantially parallel to each other. When each illuminating beam 2002 is not deflected by charge build up on the surface of the substrate, the location of each beam spot on the surface of a substrate may be substantially the same as the location of each respective beam 2002 in the final stage of the column that generates the multi-beam.

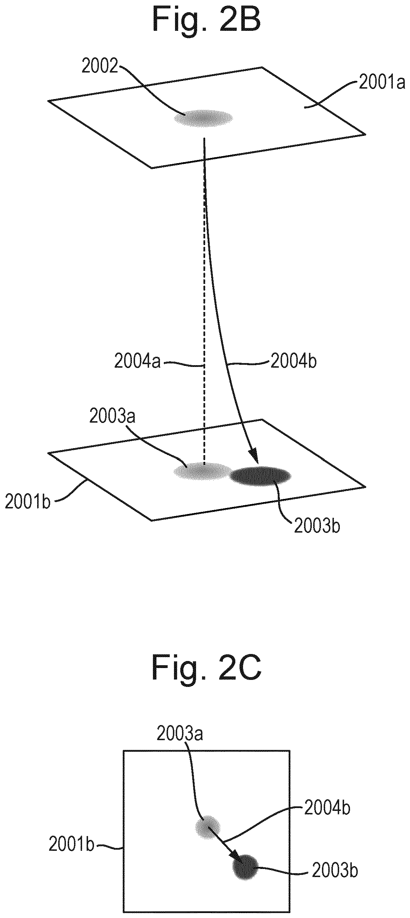

Figures 2B and 2C show the effect that charge build up on the surface of a substrate may have on an illuminating beam 2002.

In Figure 2B, grid 2001a and grid 2001b are at different locations along the optical path within the SEM metrology apparatus. Grid 2001a may be in a final stage of the column that generates the multi-beam. Grid 2001b may correspond to grid 2001a in plan view, but is instead located at the surface of the substrate.

In grid 2001a, the beam 2002 may be substantially unaffected by the charge build up and therefore correctly positioned within the grid 2001a. If there was no charge build up on the surface of the substrate, the beam 2002 may have an undeflected beam path 2004a and the corresponding beam spot in grid 2001b may be at 2003a. However, when there is charge build up on the surface of the substrate, the beam may have a deflected beam path 2004b and the corresponding beam spot in grid 2001b may be at 2003b.

Figure 2C is a plan view of grid 2001b. The effect of the charge build up is that there is a deflected beam path 2004b. The beam spot has therefore be moved, in x and y directions, from an intended location 2003a to actual location 2003b.

The placement of beam spot 2003b away from its intended location causes distortion in the SEM image generated by the SEM imaging process. For example, in a 8µm by 8µm sized SEM image, the distortion may result a displacement of 3nm to 4nm in the imaged features.

It is known to attempt to substantially correct SEM image distortion by processing the SEM images. Prior art techniques include processing by applying a 2D linear (6 parameter), or thirdorder (20 parameter), polynomial fitting.

The 20 parameter polynomial fitting is effective at substantially correcting distortion in low-frequency distortion maps. However, its effective application is limited to distortion maps with a trivial pattern density. Furthermore, the correction process by polynomial fitting assumes a random mathematical basis behind the corrected distortions. There is no physical justification behind the corrections made by polynomial fitting. Polynomial fitting is therefore prone to either under correction or over correction. Moreover, polynomial fitting applies an overall correction to all distortions in an image. There is no consideration of the separate contributions to the distortion.

Embodiments disclosed herein improve on known techniques for determining the distortion in an SEM image. Embodiments disclosed herein also improve on known techniques for reducing, or substantially correcting, the distortion in an SEM image.

In an embodiment for determining the distortion of a SEM image, the effect of charge build up on a substrate is modelled and used to determine the charging induced distortion in a SEM image. The model may determine deflection amounts based on the physical process of an illuminating beam being deflected by surface charge build up on the substrate. The determined distortion in the SEM image may only be of the charging induced distortion, so that the charging induced distortion is effectively isolated for the other causes of distortion in the SEM image. By applying processes that substantially only correct the charging induced distortion, the problem in known techniques of applying under correction, or over correction, is substantially avoided.

Embodiments are described in more detail below.

In an embodiment, the charging induced distortion of a SEM image is determined. That is to say, a determination is made of only the distortion resulting from charge build up on a substrate, or other type of sample, is made. Any other contributions to the distortion are not determined. The charging of the substrate may have been caused by the illumination of the substrate by either a single beam, or a multi-beam, of charged particles. The SEM image may correspond to all, or part of, a field of view of the SEM apparatus.

At each of a plurality of locations in a SEM image of at least part of a substrate a determination is made of the deflection of an illuminating charged particle beam caused by a charging of the sample at the location. The determined deflection may be based on a calculated electrostatic deflection given the physical properties of the beam and/or the physical properties of the substrate. The physical properties of the substrate may include the estimated charge present on, and/or beneath, the surface of the substrate. Other factors may also be used in the calculation to determine the deflection. The determination of the deflection may comprise determining both a deflection direction and also the magnitude of the deflection. The magnitude of the deflection may define the distance that an illuminating beam spot on a substrate is from its intended position had no charging induced deflection occurred. The deflection direction may define the direction in which the beam spot has been displaced relative to its intended position had no charging induced deflection occurred. The deflection direction and/or the magnitude of deflection may vary over time. The time variance of the deflection direction and/or the magnitude of deflection may also be determined.

The processing of the SEM image may comprise dividing the SEM image into a plurality of grids. Each grid may be square, hexagonal, or any other shape. The grids may be arranged in a regular and non-overlapping arrangement, such as the square grids 2001 shown in Figure 2A. Each grid may correspond to a single pixel in the SEM image, or each grid may comprise a plurality of pixels in the SEM image. Each location at which the deflection of an illuminating charged particle beam is determined may be one of the plurality of grids.

Embodiments include generating a charging induced distortion map that comprises a combination of the deflections determined at each of the plurality of locations in the SEM image. The charging induced distortion map may indicate the determined charging induced distortion of the SEM image.

The charge build up on a substrate may be dependent on a number of factors. These may include one or more of: the dose of the illumination process, the dose per pixel in the SEM image, the scan speed of the illumination process, the scanning pattern/strategy of the illumination process, the pattern density, the pattern parameters, the field of view size, the pixel size, the overscan amount, the landing energy of the charged particles, and the separation between the sample and a charged particle source during the illumination process.

In particular, a scanning pattern/strategy may comprise performing sweeps over the surface of the substrate in the ±y direction, with the sweeps starting at the ―x end of the substrate and ending at the +x end of the substrate. At the start of the scanning process the distortion may be relatively low because the amount of trapped charges on the surface of the substrate is low. However, the distortion may increase throughout the scanning process as the charge build up increases. The charging induced distortion may therefore be higher at the +x end of the substrate than at the ―x end of the substrate. In addition, the magnitude of the charge on a substrate may be dependent on the pattern density and/or the pattern parameters. The pattern parameters may include, for example, edge length.

Embodiments may determine the actual charge amount at locations on a substrate. Alternatively, embodiments may determine the deflection effect of the actual charge without the actual charge being determined. This may be performed by, for example, any of estimating an actual charge, by estimating the deflection without determining an actual, or estimated, charge, or by other techniques.

Embodiments include constructing a model to determine the deflection at each location. The model may comprise fixed parameters and variable parameters.

The fixed parameters may be defined by the circumstances under which a SEM image has been acquired. For example, the fixed parameters may comprise data on one or more of: the dose of the illumination process, the dose per pixel in the SEM image, the scan speed of the illumination process, the scanning pattern/strategy of the illumination process, the field of view size, the pattern density, the pattern parameters, the pixel size, the overscan amount, the landing energy of the charged particles, and the separation between the sample and a charged particle source during the illumination process.

The variable parameters of the model may correspond to estimated, or calculated, parameters that may have an effect on the defection of a charged particle. The variable parameters may include one or more of: estimated charging at locations on the sample, estimated charge amplitudes at locations on the sample, translation offsets, charge decay times, interactions between different charge regions and interactions between charges and matter.

The variable parameters may be difficult, or impossible, to determine from the fixed parameters alone. The variable parameters may be determined through an iterative process that tunes the variable parameters until the modelled deflections substantially correspond to measurable distortions in the SEM image.

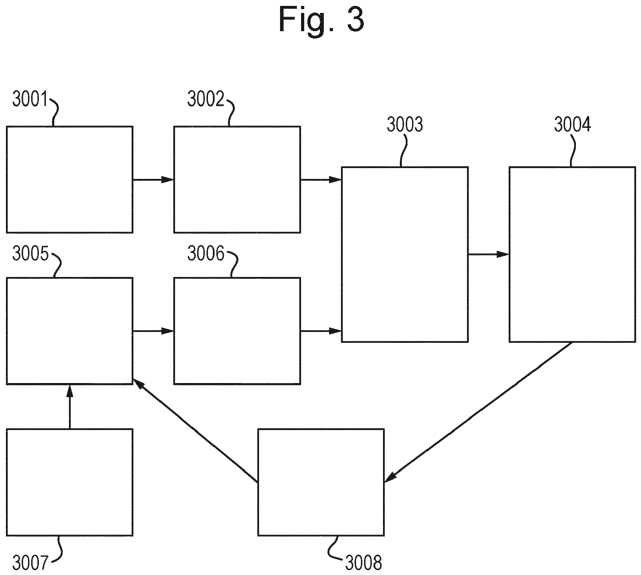

Figure 3 shows processing steps that may be performed to iteratively determine the variable parameters of the model.

In block 3001, a process may be performed for measuring the distortion in the image. The measured distortion may be referred to as an imaging error. The imaging error may be, for example, a calculation of the difference between a measured centroid of features in the SEM image and an expected centroid given the design data on the features. The imaging error may be, for example, local placement error (LPE) that is a known error metric. The imaging error in the SEM image may be referred to as an LPE fingerprint.

In block 3002, a further processing step may optionally be performed on the imaging error of the SEM image. For example, a mean subtraction may be performed. This may generate a mean-subtracted LPE fingerprint. Alternatively, or additionally, the further processing step may comprise applying a 6 parameter polynomial fit correction to the imaging error.

The further processing step that may optionally be performed on the imaging error in the SEM image may include an averaging of process based on a plurality of SEM images. For example, for each of a plurality of SEM images, a mean subtraction may be performed and an averaged imaging error obtained by averaging the results. Similarly, for each of a plurality of SEM images, a 6 parameter polynomial fit correction may be applied and an averaged imaging error obtained by averaging the results.

As described in more detail later, either the imaging error determined by the processes in block 3001, or the imaging error optionally determined by the processes in block 3002, may be used, in block 3003, in a comparison with modelled charging induced distortions.

In block 3007, the parameters of a model of the charging induced distortions may be determined. As described earlier, the model may be constructed in dependence on fixed parameters, that are defined by known circumstances and conditions under which a SEM image has been acquired, and variable parameters. The initial values of the variable parameters may be predetermined default values, or estimated values.

In block 3005, processes may then be performed for constructing the model in dependence on the fixed parameters and the variable parameters.

In block 3006, a further processing step may optionally be performed on the model. For example, a 6 parameter polynomial fit correction may be performed on the model.

In block 3003, a comparison may be made between the model and the imaging error. The comparison may be between the model as constructed in block 3005 and either the imaging error determined by the processes in block 3001, or the imaging error optionally determined by the processes in block 3002. Alternatively, the comparison may be between the model as determined in block 3006 and either the imaging error determined by the processes in block 3001, or the imaging error optionally determined by the processes in block 3002.

The comparison process may, for example, apply the model to the imaging error in a process for substantially reducing the imaging error. The remaining error after the comparison process may be measured, such as by a 3 sigma LPE process.

If the measured remaining error is at a converged minimum level, and/or below a predetermined threshold level, then the processes may be stopped and a determination made that the variable parameters of the model are suitable for achieving a desired reduction, or substantial correction, of the charging induced error in the SEM image. If the measured remaining error is not at a converged minimum level, and/or not below a predetermined threshold level, then the processes may continue at block 3008.

In block 3008, a determination may be made to change, or adjust, the values of some, or all, of the variable parameters of the model. Each change of a variable parameter may be based on whether or not one or more previous changes to the variable parameter have resulted in the measured remaining error converging, and/or reducing.

The processing may then return to block 3005 where the model is updated by the determined changes to the variable parameters in block 3008.

The above-described further processes after those in block 3005 may then be repeated until a determination is made that the variable parameters of the model are suitable for achieving a desired reduction, or substantial correction, of the charging induced error in the SEM image. Accordingly, the determination to change the values of some, or all, of the variable parameters of the model in block 3008, may be repeated as many times as required. The variable parameters of the model may therefore be determined through an iterative processes.

The above described processes determine a model of the charging induced distortions in one or more SEM images. Embodiments also include using the model to reduce, or substantially correct, the distortion in one or more SEM images. In particular, the model may be applied to a SEM image to generate a new image that does not include the modelled charging induction distortions.

Advantageously, embodiments allow the reduction, and/or substantial correction, of charging induced distortions in SEM images. The charging induced distortions may have been determined based on the known physical process of charge deflection. This differs from known techniques that apply essentially random corrections that are not justified by a physical process. Image corrections determined according to embodiments are therefore less likely to result in under correction, or over correction, of the SEM image than known techniques.

Advantageously, embodiments also provide information on the different sources of imaging error. The charging induced imaging error is determined separately from the other sources of imaging error. This provides an improved determination of the imaging error resulting from the other sources of image distortion than charge build up effects.

Advantageously, embodiments are also able to determine charging induced distortion of SEM images of part of substrates that have a complex, i.e. non-trivial, pattern density.

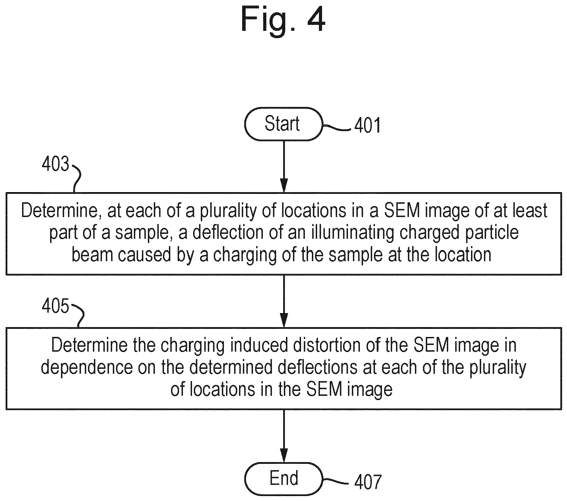

Figure 4 shows a flowchart of a method of determining the charging induced distortion of a SEM image according to an embodiment.

In the step 401, the method starts.

In step 403, at each of a plurality of locations in a SEM image of at least part of a sample, a deflection of an illuminating charged particle beam caused by a charging of the sample at the location is determined.

In step 405, the charging induced distortion of the SEM image is determined in dependence on the determined deflections at each of the plurality of locations in the SEM image. In step 407, the method ends.

Embodiments include a number of modifications and variations to the above-described techniques.

For example, the magnitude of the charge on a substrate may be dependent on the pattern of features on a substrate, and in particular the pattern density and/or the pattern parameters. The pattern parameters may include, for example, edge length. Embodiments include the determined model of the charging induced distortions being calibrated with a pattern and using this to determine the dependence of the charging induced distortions on the pattern density and/or pattern parameters. The determined dependence of the charging induced distortions on the pattern density and/or pattern parameters may be used to improve the accuracy of the calibrated charging model when it is applied to another pattern with different pattern density and/or parameters.

For example, the SEM images may have been acquired by any suitable type of SEM apparatus. The SEM apparatus may be a single beam apparatus or a multi-beam apparatus.

Although embodiments have been mostly described with reference to SEM images of at least part of a substrate, embodiments include the techniques being applied to SEM images of other type of sample.

The techniques disclosed herein can reduce the complexity of SEM processes.

The techniques disclosed herein can be used in in-line measurements for control loops and wafer disposition.

While specific techniques have been described above, it will be appreciated that the disclosure may be practiced otherwise than as described.

An embodiment may include a computer program containing one or more sequences of machine-readable instructions configured to instruct various apparatus as depicted in Figure 1A to perform measurement and optimization steps and to control a subsequent exposure process as described above. This computer program may be executed, for example, within the control unit LACU or the supervisory control system SCS of Figure 1A or a combination of both. There may also be provided a data storage medium (e.g., semiconductor memory, magnetic or optical disk) having such a computer program stored therein.

Although specific reference may have been made above to optical lithography, it will be appreciated that the techniques disclosed herein may be used in other applications, for example imprint lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 1-100 nm), as well as particle beams, such as ion beams or electron beams. Implementations of scatterometers and other inspection apparatus can be made in UV and EUV wavelengths using suitable sources, and the present disclosure is in no way limited to systems using IR and visible radiation.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

As used herein, unless specifically stated otherwise, the term "or" encompasses all possible combinations, except where infeasible. For example, if it is stated that a component may include A or B, then, unless specifically stated otherwise or infeasible, the component may include A, or B, or A and B. As a second example, if it is stated that a component may include A, B, or C, then, unless specifically stated otherwise or infeasible, the component may include A, or B, or C, or A and B, or A and C, or B and C, or A and B and C.

Aspects of the present disclosure are set out in the following numbered clauses:
1. A non-transitory computer readable medium that has stored therein a computer program, wherein the computer program comprises code that, when executed by a computer system, instructs the computer system to perform a method of determining the charging induced distortion of a SEM image, the method comprising: determining, at each of a plurality of locations in a SEM image of at least part of a sample, a deflection of an illuminating charged particle beam caused by a charging of the sample at the location; and determining the charging induced distortion of the SEM image in dependence on the determined deflections at each of the plurality of locations in the SEM image.
2. The non-transitory computer readable medium according to clause 1, wherein the charging of the sample is caused by the illumination of the sample by one or more charged particle beams.
3. The non-transitory computer readable medium according to clause 1 or 2, wherein the SEM image corresponds to a field of view of a charged particle apparatus.
4. The non-transitory computer readable medium according to any preceding clause, wherein the SEM image comprises a plurality of grids; and each one of the plurality of locations in the SEM image is one of the grids.
5. The non-transitory computer readable medium according to any preceding clause, wherein each determined deflection is determined by calculating an electrostatic deflection.
6. The non-transitory computer readable medium according to any preceding clause, wherein determining each deflection comprises determining both a deflection direction and a deflection magnitude.
7. The non-transitory computer readable medium according to any preceding clause, further comprising generating a charging induced distortion map in dependence on the determined charging induced distortion of the SEM image.
8. The non-transitory computer readable medium according to any preceding clause, wherein determining each deflection comprises modelling each deflection by a charging induced deflection model.
9. The non-transitory computer readable medium according to clause 8, wherein the input parameters of the charging induced deflection model comprise one or more of: the dose of the illumination process, dose per pixel in the SEM image, scan speed of the illumination process, scanning pattern, pattern density, pattern parameters, field of view size, pixel size, overscan amount, landing energy of the charged particles, or the separation between the sample and a charged particle source during the illumination process.
10. The non-transitory computer readable medium according to clause 8 or 9, wherein variable parameters of the charging induced deflection model comprise one or more of: estimated charging at locations on the sample, estimated charge amplitudes at locations on the sample, translation offsets, charge decay times, interactions between different charge regions or interactions between charges and matter.
11. The non-transitory computer readable medium according to any of clauses 8 to 10, the method further comprising: determining an imaging error in dependence on the features in the SEM image; and applying the charging induced deflection model to the determined imaging error; wherein one or more variable parameters of the charging induced deflection model are determined by iteratively comparing the charging model to the imaging error a plurality of times, with the one or more variable parameters adjusted in each iteration.
12. The non-transitory computer readable medium according to clause 11, wherein the imaging error is a local placement error of features in the SEM image.
13. The non-transitory computer readable medium according to clause 11 or 12, wherein the imaging error is determined in dependence on the difference between a measured centroid in a SEM image and an expected centroid in the SEM image.
14. The non-transitory computer readable medium according to any of clauses 11 to 13, the method further comprising processing the imaging error; wherein: the charging model is applied to the processed imaging error to generate the reduced imaging error; and processing the imaging error comprises one or more of: applying a 6 parameter polynomial fit correction to the imaging error; applying a mean subtraction to the imaging error; generating an averaged imaging error in dependence on a 6 parameter polynomial fit correction applied to each of a plurality of SEM images; or generating an averaged imaging error in dependence on a mean subtraction applied to each of a plurality of SEM images.
15. The non-transitory computer readable medium according to clause 11, or any clause dependent thereon, the method further comprising applying a 6 parameter polynomial fit correction to the charging model before the charging model is applied to the imaging error, or processed imaging error.
16. A non-transitory computer readable medium that has stored therein a computer program, wherein the computer program comprises code that, when executed by a computer system, instructs the computer system to perform a method of reducing charging induced distortion of a SEM image, the method comprising: determining the charging induced distortion of the SEM image in dependence on the method in any preceding clause; and using the determined charging induced distortion to reduce the charging induced imaging error in the SEM image.
17. A system for determining the charging induced distortion of a SEM image, the system comprising the computer readable medium according to any preceding clause.
18. A computer-implemented method of determining the charging induced distortion of a SEM image, the method comprising: determining, at each of a plurality of locations in a SEM image of at least part of a sample, a deflection of an illuminating charged particle beam caused by a charging of the sample at the location; and determining the charging induced distortion of the SEM image in dependence on the determined deflections at each of the plurality of locations in the SEM image.
19. The method according to clause 18, wherein the charging of the sample is caused by the illumination of the sample by one or more charged particle beams.
20. The method according to clause 18 or 19, wherein the SEM image corresponds to a field of view of a charged particle apparatus.
21. The method according to any of clauses 18 to 20, wherein the SEM image comprises a plurality of grids; and each one of the plurality of locations in the SEM image is one of the grids.
22. The method according to any of clauses 18 to 21, wherein each determined deflection is determined by calculating an electrostatic deflection.
23. The method according to any of clauses 18 to 22, wherein determining each deflection comprises determining both a deflection direction and a deflection magnitude.
24. The method according to any of clauses 18 to 23, further comprising generating a charging induced distortion map in dependence on the determined charging induced distortion of the SEM image.
25. The method according to any of clauses 18 to 24, wherein determining each deflection comprises modelling each deflection by a charging induced deflection model.
26. The method according to clause 25, wherein the input parameters of the charging induced deflection model comprise one or more of: the dose of the illumination process, dose per pixel in the SEM image, scan speed of the illumination process, scanning pattern, pattern density, pattern parameters, field of view size, pixel size, overscan amount, landing energy of the charged particles, or the separation between the sample and a charged particle source during the illumination process.
27. The method according to clause 25 or 26, wherein variable parameters of the charging induced deflection model comprise one or more of: estimated charging at locations on the sample, estimated charge amplitudes at locations on the sample, translation offsets, charge decay times, interactions between different charge regions or interactions between charges and matter.
28. The method according to any of clauses 25 to 27, further comprising: determining an imaging error in dependence on the features in the SEM image; and applying the charging induced deflection model to the determined imaging error; wherein one or more variable parameters of the charging induced deflection model are determined by iteratively comparing the charging model to the imaging error a plurality of times, with the one or more variable parameters adjusted in each iteration.
29. The method according to clause 28, wherein the imaging error is a local placement error of features in the SEM image.
30. The method according to clause 28 or 29, wherein the imaging error is determined in dependence on the difference between a measured centroid in a SEM image and an expected centroid in the SEM image.
31. The method according to any of clauses 28 to 30, further comprising processing the imaging error; wherein: the charging model is applied to the processed imaging error to generate the reduced imaging error; and processing the imaging error comprises one or more of: applying a 6 parameter polynomial fit correction to the imaging error; applying a mean subtraction to the imaging error; generating an averaged imaging error in dependence on a 6 parameter polynomial fit correction applied to each of a plurality of SEM images; or generating an averaged imaging error in dependence on a mean subtraction applied to each of a plurality of SEM images.
32. The method according to clause 28, or any clause dependent thereon, further comprising applying a 6 parameter polynomial fit correction to the charging model before the charging model is applied to the imaging error, or processed imaging error.
33. A computer-implemented method of reducing charging induced distortion of a SEM image, the method comprising: determining the charging induced distortion of the SEM image in dependence on the method of any of clauses 18 to 32; and using the determined charging induced distortion to reduce the charging induced imaging error in the SEM image.
34. A computer program comprising code that, when executed by a computer system, instructs the computer system to perform the method according to any of clauses 18 to 33.
35. An inspection tool comprising: an imaging system configured to image a portion of a semiconductor substrate; and an image analysis system that comprises the system of clause 17 and is configured to perform a method for determining the charging induced distortion of a SEM image.
36. A method of manufacture of a semiconductor substrate, the method comprising the steps of:
   manufacturing at least part of the semiconductor substrate; performing the computer-implemented method according clause 33; analyzing the aligned image to obtain a metric of the image; and
   comparing the metric to a target metric and taking remedial action when the metric does not meet the target metric.
37. A semiconductor substrate manufacturing system comprising apparatuses configured to perform the method of clause 36.
38. A non-transitory computer readable medium that has stored therein a computer program, wherein the computer program comprises code that, when executed by a computer system, instructs the computer system to perform a method of reducing charging induced distortion of a SEM image, the method comprising: determining the charging induced distortion of a SEM image; and
   reducing charging induced distortion in the SEM image in dependence on the determined charging induced distortion.
39. The non-transitory computer readable medium according to clause 38, the method further comprising determining charging induced deflections at each of a plurality of locations in the SEM image; wherein the charging induced distortion is determined in dependence on the determined charging induced deflections.
40. The non-transitory computer readable medium according to clause 39, further comprising using a charging induced deflection model to determine the charging induced deflections.
41. The non-transitory computer readable medium according to clause 40, wherein the charging induced deflection model determines the charging induced deflections based on the physical properties of charge interactions.
42. The non-transitory computer readable medium according to clause 41, further comprising applying the charging induced deflection model to the SEM image to reduce the imaging error in the SEM image.
43. The non-transitory computer readable medium according to any of clauses 41 or 42, wherein one or more variable parameters of the charging model are determined by an iterative process.
44. A system for determining the charging induced distortion of a SEM image, the system comprising the computer readable medium according to any of clauses 38 to 43.
45. A computer-implemented method of reducing charging induced distortion of a SEM image, the method comprising: determining the charging induced distortion of a SEM image; and
   reducing charging induced distortion in the SEM image in dependence on the determined charging induced distortion.
46. The method according to clause 45, further comprising determining charging induced deflections at each of a plurality of locations in the SEM image; wherein the charging induced distortion is determined in dependence on the determined charging induced deflections.
47. The method according to clause 46, further comprising using a charging induced deflection model to determine the charging induced deflections.
48. The method according to clause 47, wherein the charging induced deflection model determines the charging induced deflections based on the physical properties of charge interactions.
49. The method according to clause 48, further comprising applying the charging induced deflection model to the SEM image to reduce the imaging error in the SEM image.
50. The method according to any of clauses 48 or 49, wherein one or more variable parameters of the charging model are determined by an iterative process.
51. A non-transitory computer readable medium that has stored therein a computer program, wherein the computer program comprises code that, when executed by a computer system, instructs the computer system to perform a method of reducing charging induced distortion of a SEM image, the method comprising: modelling the charging induced distortion of a SEM image, wherein the model comprises estimating the deflection of an illuminating charged particle beam by a charge on an illuminated sample; and using the modelled charging induced distortion in the SEM image to reduce the charging induced distortion in the SEM image.
52. A system for determining the charging induced distortion of a SEM image, the system comprising the computer readable medium according to clauses 51.
53. A computer-implemented method of reducing charging induced distortion of a SEM image, the method comprising: modelling the charging induced distortion of a SEM image, wherein the model comprises estimating the deflection of an illuminating charged particle beam by a charge on an illuminated sample; and using the modelled charging induced distortion in the SEM image to reduce the charging induced distortion in the SEM image.
54. A non-transitory computer readable medium that has stored therein a computer program, wherein the computer program comprises code that, when executed by a computer system, instructs the computer system to perform a method of correcting charging induced distortion of a SEM image, the method comprising: determining, for each grid of a plurality of grids of a field of view, a deflection of an e-beam that results from charging of a sample by the e-beam; and correcting a distortion of a SEM image of the sample based on the determined deflections.
55. A system for determining the charging induced distortion of a SEM image, the system comprising the computer readable medium according to clause 54.
56. A computer-implemented method of correcting charging induced distortion of a SEM image, the method comprising: determining, for each grid of a plurality of grids of a field of view, a deflection of an e-beam that results from charging of a sample by the e-beam; and correcting a distortion of a SEM image of the sample based on the determined deflections.
57. A non-transitory computer readable medium that has stored therein a computer program, wherein the computer program comprises code that, when executed by a computer system, instructs the computer system to perform the method of clause 56.
58. A system for determining the charging induced distortion of a SEM image, the system comprising the computer readable medium according to clause 57.

Having described embodiments of the invention it will be appreciate that variations thereon are possible within the spirit and scope of the disclosure and the appended claims as well as equivalents thereto.

## Claims

1. A non-transitory computer readable medium that has stored therein a computer program, wherein the computer program comprises code that, when executed by a computer system, instructs the computer system to perform a method of determining the charging induced distortion of a SEM image, the method comprising:
determining, at each of a plurality of locations in a SEM image of at least part of a sample, a deflection of an illuminating charged particle beam caused by a charging of the sample at the location; and
determining the charging induced distortion of the SEM image in dependence on the determined deflections at each of the plurality of locations in the SEM image.

2. The non-transitory computer readable medium according to claim 1, wherein the charging of the sample is caused by the illumination of the sample by one or more charged particle beams.

3. The non-transitory computer readable medium according to claim 1, wherein the SEM image corresponds to a field of view of a charged particle apparatus.

4. The non-transitory computer readable medium according to claim 1, wherein each determined deflection is determined by calculating an electrostatic deflection.

5. The non-transitory computer readable medium according to claim 1, wherein determining each deflection comprises determining both a deflection direction and a deflection magnitude.

6. The non-transitory computer readable medium according to claim 1, wherein determining each deflection comprises modelling each deflection by a charging induced deflection model.

7. The non-transitory computer readable medium according to claim 6, wherein the input parameters of the charging induced deflection model comprise one or more of: the dose of the illumination process, dose per pixel in the SEM image, scan speed of the illumination process, scanning pattern, pattern density, pattern parameters, field of view size, pixel size, overscan amount, landing energy of the charged particles, or the separation between the sample and a charged particle source during the illumination process.

8. The non-transitory computer readable medium according to claim 6, wherein variable parameters of the charging induced deflection model comprise one or more of: estimated charging at locations on the sample, estimated charge amplitudes at locations on the sample, translation offsets, charge decay times, interactions between different charge regions or interactions between charges and matter.

9. The non-transitory computer readable medium according to claim 6, the method further comprising:
determining an imaging error in dependence on the features in the SEM image; and
applying the charging induced deflection model to the determined imaging error;
wherein one or more variable parameters of the charging induced deflection model are determined by iteratively comparing the charging model to the imaging error a plurality of times, with the one or more variable parameters adjusted in each iteration.

10. The non-transitory computer readable medium according to claim 9, wherein the imaging error is a local placement error of features in the SEM image.

11. The non-transitory computer readable medium according to claim 9, wherein the imaging error is determined in dependence on the difference between a measured centroid in a SEM image and an expected centroid in the SEM image.

12. The non-transitory computer readable medium according to any of claim 9, the method further comprising processing the imaging error; wherein:
the charging model is applied to the processed imaging error to generate the reduced imaging error; and
processing the imaging error comprises one or more of:
applying a 6 parameter polynomial fit correction to the imaging error;
applying a mean subtraction to the imaging error;
generating an averaged imaging error in dependence on a 6 parameter polynomial fit correction applied to each of a plurality of SEM images; or
generating an averaged imaging error in dependence on a mean subtraction applied to each of a plurality of SEM images.

13. The non-transitory computer readable medium according to claim 9, or any claim dependent thereon, the method further comprising applying a 6 parameter polynomial fit correction to the charging model before the charging model is applied to the imaging error, or processed imaging error.

14. A non-transitory computer readable medium that has stored therein a computer program, wherein the computer program comprises code that, when executed by a computer system, instructs the computer system to perform a method of reducing charging induced distortion of a SEM image, the method comprising:
determining the charging induced distortion of the SEM image in dependence on the method in claim 1; and
using the determined charging induced distortion to reduce the charging induced imaging error in the SEM image.

15. A system for determining the charging induced distortion of a SEM image, the system comprising the computer readable medium according to claim 1.
